(19) Europäisches Patentamt

European Patent Office

Office européen des brevets

(11) **EP 2 966 780 A1**

(12) **EUROPEAN PATENT APPLICATION**

(43) Date of publication:
**13.01.2016 Bulletin 2016/02**

(51) Int Cl.:
*H03M 1/06* (2006.01)      *H03M 1/40* (2006.01)

(21) Application number: **14306111.7**

(22) Date of filing: **07.07.2014**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **STMicroelectronics International N.V.**
**1118 BH Amsterdam (NL)**

(72) Inventor: **Vaccariello, Laurent**
**38000 GRENOBLE (FR)**

(74) Representative: **Casalonga**
**Casalonga & Partners**
**Bayerstraße 71/73**
**80335 München (DE)**

(54) **Analog-to-digital converter offset cancellation**

(57)      There is described a cyclic pipelined Analog-to-Digital Converter having an input (41) adapted to receive an analog voltage ($V_{IN}$) to be converted, and an output (42) adapted to deliver a n-bit digital value ($N_{OUT}$). The converter also comprises a core stage (40) comprising an Analog-to-Digital Conversion stage (50) to provide at least one bit value of the n-bit digital value at each one of a plurality of successive conversion steps performed in loop by the core stage (40). The core stage (40) further comprises a differential inputs-differential outputs amplifier (59). In order to cancel the offset of the stage (55, 58), the coupling of the amplifier inputs is inversed, i.e. the inputs are switched around, namely swapped, just after the first conversion step has been carried out. Simultaneously the differential outputs of the amplifier are similarly swapped.

$$V_{OUT\_CORE} = 2 \cdot V_{IN} \pm \frac{V_{REF}}{2}$$

**FIG. 4**

## Description

## BACKGROUND

## Technical Field

The present invention generally relates to analog-to-digital conversion, and more particularly to techniques for minimizing the effects of offset in an Analog-to-Digital Converter (ADC).

## Related Art

The approaches described in this section could be pursued, but are not necessarily approaches that have been previously conceived or pursued. Therefore, unless otherwise indicated herein, the approaches described in this section are not prior art to the claims in this application and are not admitted to be prior art by inclusion in this section.

Analog-to-Digital converters (ADC) translate analog signals which may be, for example, measurement voltages reflecting any kind of phenomena in the real world, to digital format to be used in information processing, computing, data transmission, control systems, etc. More precisely, a sampled voltage value lying within the ADC input range is converted into an output code word having a given number N of bits, which may take any one of $2^N$ binary values ranging between 0 and $2^N$-1.

ADC converter architectures are often chosen based on conversion speed and/or accuracy specifications. It is generally assumed, for example, that a sigma-delta converter will exhibit better conversion accuracy than a flash ADC, and that a pipeline ADC will be faster than a sigma-delta converter. Further key performance characteristics of ADCs comprise design complexity and used silicon area, as well as power consumption.

Beside many other ADC architectures such as oversampling/sigma-delta ADCs and flash ADCs, for instance, the pipelined ADC has become one of the most popular ADC architecture for sampling rates ranging from a few megasamples per second (Msps) up to 100 Msps and more. It finds applications, for example, in CCD imaging, ultrasonic medical imaging, digital receivers, base stations, digital video (for example, HDTV), xDSL, cable modems, and fast Ethernet. The achieved resolution ranges from 8 bits at the faster sampling rates up to 16 bits at the lower rates, which is generally sufficient in the above examples of application.

A classic pipeline ADC comprises serially connected elementary stages, each of which is adapted to compute a conversion by deciding whether the analog input value is over or under a reference value. The conversion error voltage (also named the residue) of each stage is presented to the subsequent stage as a 'weighted' voltage to be computed for obtaining the following bit. For each decision, the residue is calculated with keeping half the range selected for the previous step and re-adapting it to the input full-scale. The ADC comprises means for memorizing the binary values thus obtained at the output of each stage, which constitute the final output digital word.

In a cyclic pipelined ADC architecture, also known as an algorithmic converter, only one core stage is used several times to successively produce the digital bits of the output code word. Stated otherwise, one and the same core stage is used to run successive steps of one data conversion, each step generally providing 1 or 2 effective bits of the output codeword.

The offset which affects overall conversion process is growing with the number of conversion steps, reaching $2^N$-1 times the offset of the single, core stage after N steps have been computed.

When the offset of the ADC transfer characteristic is too excessive, the generally used solution is to add calibration means adapted to carry out offset cancellation. However, this includes integrating analog and digital glue to perform a periodic or initial offset cancellation. Stated otherwise, calibration of the ADC must be performed periodically or must be applied when the circuit starts-up. In addition, the calibration means increase the design complexity and the used silicon area.

## SUMMARY

To address these needs, a first aspect of the present invention relates to a cyclic pipelined Analog-to-Digital Converter (ADC) having:

- an input adapted to receive an analog voltage to be converted, and an output adapted to deliver a n-bit digital value, where n is an integer greater than 1;

- a core stage comprising:

  - an Analog-to-Digital Conversion stage adapted to compare the voltage between said differential inputs to at least one threshold value ($V_{REF}$, $V_{REF\_HIGH}$, $V_{REF\_LOW}$) and to provide at least one bit value of the n-bit digital value at each one of a plurality of successive conversion steps performed in loop by the core stage, respectively;

  - a stage having:

    - first and second inputs;

    - first and second outputs; and,

    - a differential inputs-differential outputs amplifier adapted to compute a multiplication by 2 using a set of switched-capacitances;

    - a differential inputs-single ended output comparator adapted to deliver a digital output;

- a Digital-to-Analog Converter adapted to convert the digital output delivered by said comparator into a voltage level that is subtracted from the differential outputs of a multiplier by 2,

- a load of capacitances adapted to execute a voltage subtraction ;

- a first differential multiplexer arranged between the first and second inputs of the stage and the differential inputs of the amplifier, and adapted to selectively couple a given ordered pair of said first and second inputs to one of first and second ordered pairs of the differential inputs in a first operating configuration of the stage and to couple said ordered pair of said first and second inputs to the other of said first and second ordered pairs of said differential inputs in a second operating configuration of the stage;

- a second differential multiplexer arranged between the differential outputs of the amplifier and the first and second outputs of the stage, and adapted to selectively a given ordered pair of said differential outputs to one of first and second ordered pairs of said first and seconds outputs in the first operating configuration of the stage, and to couple said ordered pair of said differential outputs to the other of said first and second ordered pairs of said first and second outputs in the second operating configuration of the stage;

- a control unit adapted to control the first and second differential multiplexers to set the stage into the first operating configuration for the performance of the first conversion step of the plurality of conversion steps, and into the second operating configuration for the performance of any of the subsequent conversion steps of the plurality of conversion steps.

A digital correction circuit for a pipelined ADC is further disclosed.

In a cyclic pipelined ADC of the above type, the same offset value impairs the result of each conversion step, and the conversion error (residue) of the amplifier used in this core stage is doubled at each conversion step. This specific property is used to cancel, or at least significantly lower the offset which affects the overall data conversion. With embodiment of the proposed ADC, indeed, the resulting offset does not grow with the number of successive steps of the conversion process. The technical function of embodiments relies on the fact that the cyclic pipeline ADC uses the same amplifier to run all the successive steps that the overall conversion requires for each voltage sample provided at the input of the ADC.

Embodiments thus allow obtaining an efficient offset cancellation for the cyclic pipeline ADC even for the larger values of offset commonly observed in this kind of architecture. Thus, the scale range of the conversion is significantly improved. Compared to conventional digital correction circuits which use adders for performing calculations in the ADC digital correction part, and hence need a rather long time, the speed of the proposed cyclic pipelined ADC is not jeopardized.

In addition, the above results are achieved using a few additional components only, so that the additional silicon area required to implement the proposed solution is small.

In embodiments of the cyclic pipelined Analog-to-Digital Converter the conversion stage is a 1.5 bits Analog-to-Digital Converter.

Moreover, in embodiments of the cyclic pipelined Analog-to-Digital Converter the conversion stage is adapted to provide one bit value of the n-bit digital value along with a redundancy bit value at each one of the plurality of successive conversion steps.

Embodiments of the cyclic pipelined Analog-to-Digital Converter may comprise:

- a controlled switch having a first input coupled to the input of the converter to receive the analog voltage to be converted, and a second input to receive an analog residue voltage which depends on a previous conversion step, and corresponding to an output of said core stage, and an output coupled to said first input in a first operating configuration of the Analog-to-Digital Converter or to said second input in a second operating configuration of said converter;

- a Sample-and-Hold, SH circuit having an input connected to the output of the controlled switch and adapted to capture a voltage value of the analog voltage to be converted in the first operating configuration of the Analog-to-Digital Converter or a voltage value of the analog residue voltage in the second operating configuration of said converter.

In embodiments of the cyclic pipelined Analog-to-Digital Converter the first differential multiplexer comprises:

- two first controlled switches adapted to couple the first input to one of the differential inputs of the amplifier, respectively, in the first operating configuration of the conversion stage, and to the other of the differential inputs of the amplifier, in the second operating configuration of the conversion stage, respectively;

- two second controlled switches adapted to couple the second input to one of the differential inputs of the amplifier, respectively, in the first operating configuration of the conversion stage, and to the other of the differential inputs of the amplifier, in the second operating configuration of the conversion stage, respectively.

Also, in embodiments of the cyclic pipelined Analog-to-Digital Converter the second differential multiplexer comprises:

- two first controlled switches adapted to couple the first output to one of the differential outputs of the amplifier, respectively, in the first operating configuration of the conversion stage, and to the other of the differential outputs of the amplifier, in the second operating configuration of the conversion stage, respectively;

- two second controlled switches adapted to couple the second output to one of the differential outputs of the amplifier, respectively, in the first operating configuration of the conversion stage, and to the other of the differential outputs of the amplifier, in the second operating configuration of the conversion stage, respectively.

A second aspect of the present invention relates to a computer program product comprising one or more stored sequences of instructions that are accessible to a processor and which, when executed by the processor, cause the processor to carry out the steps of the method of the first aspect of the present invention.

**BRIEF DESCRIPTION OF THE DRAWINGS**

Embodiments of the present invention are illustrated by way of example, and not by way of limitation, in the figures of the accompanying drawings, in which like reference numerals refer to similar elements and in which:

- **FIG.1** shows ADC transfer characteristics without and with voltage offset;

- **FIG.2** illustrates an example of a 4-bit conversion pipeline;

- **FIG.3A** illustrates the theoretical selection zones of a classic 1-bit conversion stage, and **FIG.3B** illustrates the selection zones of a 1-bit conversion stage with redundancy code;

- **FIG.4** is a simplified block diagram of a pipeline ADC according to embodiments with, e.g., a 1.5 bit elementary stage.

- **FIG.5A** is a simplified block-diagram of a possible implementation of a proposed pipeline ADC based on a differential-inputs / differential-outputs voltage amplifier;

- **FIG.5B** shows the core stage of FIG.5A with inverted inputs and inverted outputs with respect to the configuration as shown in FIG.5A;

- **FIG.6** is a simplified block-diagram of a possible implementation of the core stage of the proposed pipeline ADC, with input and output multiplexing means;

- **FIG.7A** shows the core stage of FIG.6, in a configuration for use in a first step of the ADC conversion;

- **FIG.7B** shows the core stage of FIG.6, in another configuration for use in any subsequent steps of the ADC conversion;

- **FIG.8** is a flow chart illustrating steps of an analog-to-digital conversion method according to embodiments;

- **FIG.9** shows ADC transfer characteristics without and with implementation of the proposed embodiments; and,

- **FIG.10** shows graphs which illustrate the ADC output offset as a function of the core stage amplifier offset, without and with implementation of the proposed embodiments.

**DESCRIPTION OF PREFERRED EMBODIMENTS**

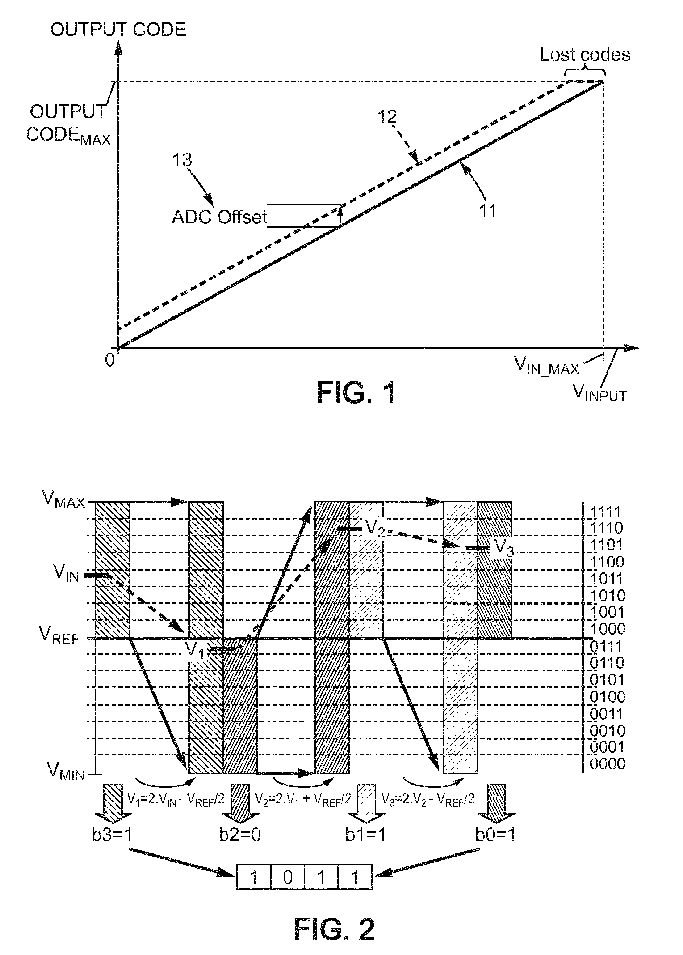

With reference to **FIG.1,** an ideal Analog-to-Digital Converter (ADC) transfer characteristic 11 is linear and has no voltage offset. Namely, it is a rectilinear curve going from the origin {0,0} where the output code word corresponding to the output digital value is $<000...00>N$ for a zero input analog voltage, to the extreme point which is reached when the output is the maximum code word $<111....11>_N$ issued for the maximum voltage value $V_{IN\_max}$ of the ADC input range, with N being the number of output bits of the ADC.

However, even an ADC designed so that it has a minimized intrinsic offset exhibits an actual ADC transfer characteristic 12 with a voltage offset 13 whereby the output code word is higher (or lower) than $<100...00>_N$ when the input voltage is half the voltage range (because the offset can be a negative or positive voltage value). This results in lost output codes, as shown in FIG.1, which may range from a few LSBs (Least Significant Bits) to between ca. 20 and ca. 30 LSBs, for instance.

Parameters of the ADC, which include but are not limited to the voltage offset (such parameters may further include linearity, for instance) can be improved by calibration, which usually implements a digital correction by adding/subtracting correction value to/from the output code word. This can be achieved by adding a block (analog and/or digital) adapted to apply an offset cancellation. The resulting offset may then equal zero, but it results in additional silicon area being used by the ADC and makes the ADC lose a portion of the input range and some output codes, as further shown in FIG.1.

An option may be to slightly modify the transfer function gain so that a maximum offset does not make the ADC lose any extreme codes. A simple "algorithmic" correction (namely by addition or subtraction) may this be used to adapt the full-scale to the one required in any specific application. That way, the offset may be cancelled without adding any analog/digital block, but the overall conversion accuracy is degraded.

Proposed embodiments allow obtaining an efficient offset cancellation for a cyclic pipeline ADC even for the larger values of offset exhibited by commonly designed ADC having this kind of architecture. As will become more apparent from the description below, this is achieved by using a few additional elementary components only.

As does know the one with ordinary skills in the art, a cyclic pipeline ADC uses the same core amplifier to run all the successive steps that the overall conversion requires for each sample at input. Thus, the same offset value is running throughout the different core stage calculations. This specific property is used to cancel the offset, according to embodiments.

The 'classic' pipeline ADC is adapted to compute a conversion with deciding, for each different stage, whether the analog value is over or under a reference voltage value and outputting a binary value which equals 1 or 0, respectively. The sum of the reference voltage values weighted by the respective output binary values equals the signal sample being converted. The principle of the conversion is done by sequentially subtracting the reference voltage values from the input sample until the residue voltage value becomes less than the desired Least Significant Bit (LSB), indicating that the weighted sum of the reference voltage values equals the original sample value. By memorizing the binary output values respectively obtained at each step, the final output digital word is constituted step-by-step. At each step, the voltage 'residue' is presented to the successive stage as the 'weighted' voltage to be computed for obtaining the following bit. For each decision, the residue is calculated with keeping half the range selected for the previous step as the input range, and with re-adapting it with respect to said input range full-scale.

Contrary to the 'classic' pipeline ADC architecture as described above, a cyclic pipeline ADC of some embodiments of the invention loops one elementary stage on itself, thus having a residue output presented at an input of the same conversion block but for a successive clock cycle.

**FIG.2** illustrates the basic concept of conversion by a pipeline ADC, in a simplified example wherein a simple 4 bits conversion is run, with V1, V2 and V3 being the three successive residue voltages processed at the second, the third and the fourth conversion steps, respectively. In FIG.2, the vertical axis represents the input range (on the left) and gives the ADC output code words on the right. The successive conversion steps as illustrated from left to right. In the example, the first comparison shows that $V_{IN} > V_{REF}$, where $V_{REF}$ is the reference value used for all comparisons. Thus, bit 3 is set to 1. The ADC output is then set to <1000> and the second comparison is performed. As $V_{IN} < V_{DAC}$, bit 2 of the output code is set to 0. The DAC output is then set to <1000>, and the third comparison is performed. Bit 1 of the output code is set to 1, and the DAC output is then set to <1010> for the final comparison. Finally, bit 0 remains at 1 because $V_{IN} > V_{REF}$ and the final DAC output value is then set to <1011>.

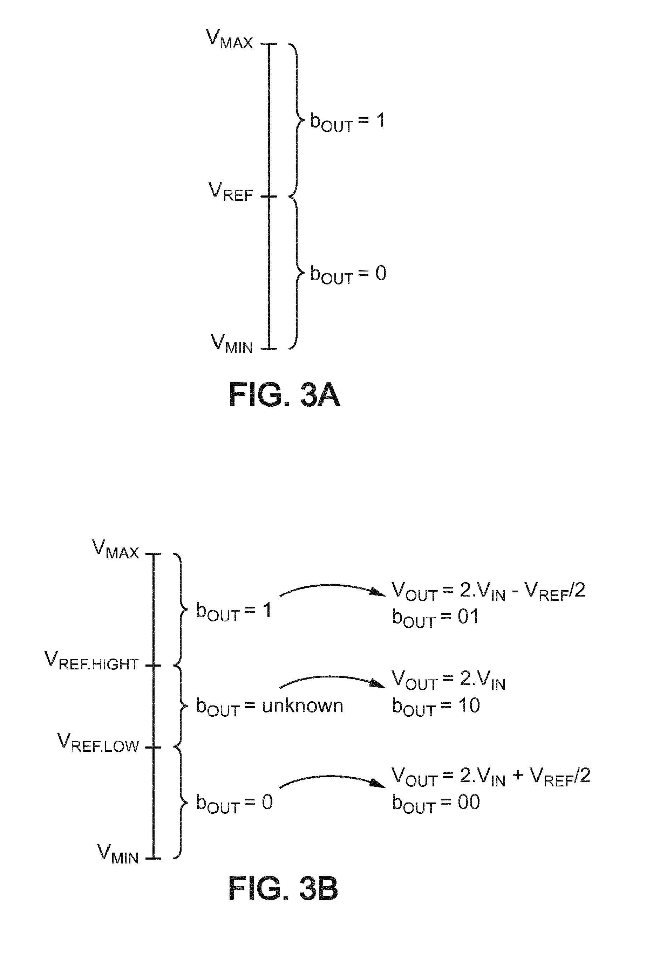

A 1-bit pipeline ADC is an ADC whose input range has two regions (High and Low) separated by the reference voltage $V_{REF}$, as illustrated in **FIG.3A,** for instance. However, the reference voltage $V_{REF}$ experiments offset which is a problem for pipeline conversion. As the one with ordinary skills in the art knows, this problem may be solved by adding a redundancy bit, so that the result is a 2-bit digital output value $b_{OUT}$ as illustrated in **FIG.3B.** In this case the ADC is named a 1.5 bit pipeline ADC.

A 1.5-bit pipeline ADC comprises two comparators and compares the analog input to the comparator reference values of thresholds $V_{REF\_HIGH}$ and $V_{REF\_LOW}$, which may be -0.25V and +0.25V in one example, for e.g. an input range of [-1V,+1V]. The name "1.5-bit ADC" indicates that there are three regions on the $V_{OUT}$ versus $V_{IN}$ which gives transfer characteristics. The ADC then gives a 2-bit output value $b_{OUT}$, namely a pair of output bits corresponding to the region in which the analog input falls, as is detailed below. The residue voltage $V_{OUT\_CORE}$ value then depends on the region in which the analog value $V_{IN}$ input to the 1.5 pipeline ADC falls, namely:

- if $V_{IN} > V_{REF\_HIGH}$ then

$$V_{OUT_{CORE}} = 2V_{IN} - \frac{V_{REF}}{2}$$ with

$$\frac{V_{REF}}{2} = \frac{V_{REF_{HIGH}} - V_{REF_{LOW}}}{4}$$ and the digital output value $b_{OUT}$ is given by $b_{OUT}$ = 01;

- if $V_{REF\_LOW} < V_{IN} < V_{REF\_HIGH}$ then $V_{OUT_{CORE}} = 2V_{IN}$ and the digital output value $b_{OUT}$ is given by $b_{OUT}$ = 10;

- of $V_{IN} < V_{REF\_LOW}$ then

$$V_{OUT_{CORE}} = 2V_{IN} + \frac{V_{REF}}{2}$$ and the digital output value $b_{OUT}$ is given by $b_{OUT}$ = 00.

The use of a redundancy bit as per the above example normally allows the ADC to get rid of the comparator offsets. Thus it is possible to have a one-step decision with no error due to comparator offset and the overall code word can be corrected by a fully integrated digital offset correction scheme. Embodiments of the cyclic pipeline ADC which will be described in what follows, preferably uses a redundancy bit, though not being compulsory.

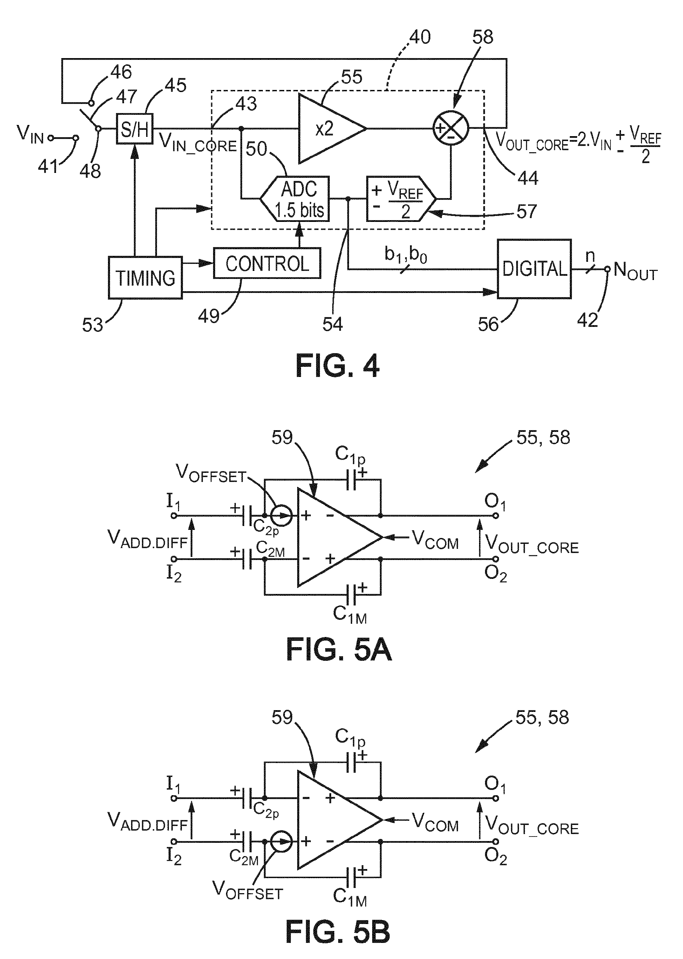

With reference to **FIG.4,** there is shown therein a simplified schematic of an example of 1.5 bit elementary stage of a cyclic pipelined ADC, to which the proposed solution may thus be applied. The cyclic pipelined Analog-to-Digital Converter has an input 41 adapted to receive the analog voltage $V_{IN}$ to be converted. The converter also has an output 42 adapted to deliver an n-bit digital value $N_{OUT}$, where n is an integer greater than 1, which is the ADC output code word.

The converter comprises a core stage 40 running all successive steps of conversion. This core stage has an input 43 adapted to receive an analog voltage $V_{IN\_CORE}$ to be converted at a current conversion step, an output 54 adapted to deliver a 2-bit digital value $b_{OUT}$. The core stage 40 has an output 44 adapted to deliver an analog residue voltage $V_{OUT\_CORE}$ for each conversion step to which the following conversion step is applied.

The output 42 is driven by a digital block 56 which receives the 2-bit digital value $b_{OUT}$ from the output 54 at each conversion step. The digital block 56 memorizes the series of bits thus received step by step in order to deliver at the output 42 an n-bit digital value once all conversion steps are done. Additionally, a conventional digital correction scheme as describe above with reference to FIG.3B is performed by the digital block 56 by using the redundancy bit.

The ADC also comprises a timing block 53 to synchronize all the digital components, the change of configuration of the ADC and the output data rate flow.

The converter further comprises a controlled switch 47 having a first input coupled to the input 41 for receiving the analog voltage $V_{IN}$, a second input 46 coupled to the output 44 of the core stage for receiving the analog residue voltage, and an output 48 coupled to a Sample-and-Hold (SH) circuit 45. The SH circuit 45 has an input connected to the output of the controlled switch and an output connected to the input 43 of the core stage 40.

The SH circuit 45 is a device that samples, namely captures or grabs the voltage of the continuously varying analog input signal and holds, namely locks or freezes its value at a constant level for a specified minimum period of time. It is used to eliminate variations in the input signal during any conversion step, which could corrupt the ongoing data conversion process.

A given number of clock cycles are necessary to sample and hold the input voltage before conversion can start.

The core stage 40 calculates the analog residue voltage $V_{OUT\_CORE}$ from the analog voltage $V_{IN\_CORE}$ and from the reference voltage $V_{REF}$. As explained in the above with respect to FIG.3B the residue voltage $V_{OUT\_CORE}$ value depends on the region in which the voltage $V_{IN\_CORE}$ input to the 1.5bit pipeline ADC falls. Firstly, a scaling is made with respect to the selected region. This scaling may consist in multiplying the voltage $V_{IN\_CORE}$ by 2. To that end, the cyclic pipelined ADC as shown includes a multiplier 55 for amplifying the analog voltage $V_{IN\_CORE}$ being converted during the ongoing conversion step. This multiplier 55 has a gain of two, namely a gain G with G=2. This amplification corresponds to a direct path of the core stage 40. Secondly, a re-center offset is added to re-center the output voltage with respect to the outcome of the comparison performed by a reverse path of the core stage 40. Stated otherwise, the added re-center offset is dependent on the region, out of the three regions as shown in FIG.3B (top, bottom, or center) in which the analog voltage $V_{IN\_CORE}$ being processed falls. The core stage 40 further comprises a 1.5bit Analog-to-Digital Conversion stage 50 which identifies the region. The scaling may be achieved by a Digital-to-Analog Conversion stage 57 which adds or subtracts half of the reference voltage value $V_{REF}$ respectively to the region. Then the core stage 40 further comprises a circuit 58 adapted to sum the signal of, respectively, the direct path and the reverse path of the core stage 40.

The 1.5bit Analog-to-Digital Conversion stage 50 is adapted to compare the voltage between the differential inputs to one threshold value $V_{REF}$ in the case of a 1-bit conversion stage 50 complying to FIG.3A, or to two threshold values $V_{REF\_HIGH}$ and $V_{REF\_LOW}$ in the case of a 1.5-bit conversion stage 50 complying to FIG.3B. The stage 50 is adapted to provide bit values of the n-bit digital value at each one of the successive conversion steps which are performed in loop by the core stage 40, along with a redundancy bit in the case of a 1.5 bit conversion stage.

The Digital-to- Analog Conversion stage 57 is adapted to receive the bit value from the stage 50 and to convert this value to an analogic signal complying with FIG.3B.

The multiplier 55 causes addition of an undesired offset value $V_{OFFSET}$ to the analog residue voltage value $V_{OUT\_CORE}$.

To sum up, the analog residue voltage reads:

$$V_{OUT_{CORE}} = 2V_{IN} \pm \frac{V_{REF}}{2} + V_{OFFSET}$$ It will be appreciated by the one with ordinary skills in the art, that in the context of the example as described herein, we have:

$$\frac{V_{REF}}{2} = \frac{V_{REF_{HIGH}} - V_{REF_{LOW}}}{4}.$$

Each of the successive conversion steps leads to one analog residue voltage $V_{OUT\_CORE}$ calculation. Hence the successive residue voltage values show a growing offset to reach the final value of $V_{N,OUT_{CORE}} = 2^N V_{IN} + (2^N - 1)V_{OFFSET}$. It results there from that the offset $V_{OFFSET}$ does affect the ADC transfer function significantly because the offset correction scheme varied out by the digital block 56 using the redundancy bit, is likely overflow so that the offset correction cannot be achieved properly. To address this problem, embodiments of the proposed solution made use of the additional feature which will now be described in details.

With reference to **FIG.5A** and **FIG.5B,** the multiplier 55 and the circuit 58 are regrouped in a functional schema represented a stage 55, 58 of the direct path. The stage 55, 58 has first and second inputs I1 and I2, respectively, and first and second outputs O1 and O2, respectively. The stage 55, 58 further comprises an amplifier 59 which has a function of error amplifying.

In FIG.5A and FIG.5B, the offset contribution may be conveniently represented by a simplified DC voltage source arranged at one of the differential inputs of the amplifier 59.

In order to cancel this offset, namely to significantly reduce the resulting effect of this offset in the final output code, the coupling of the amplifier 59 inputs is inversed, i.e. the inputs are switched around, namely swapped, just after the first conversion step has been carried out. Simultaneously the differential outputs of the amplifier 59 are similarly swapped, so as not to change the functionality of the amplifier 59. Thus, only the sign of the offset is inversed. What is achieved is that the voltage $V_{OFFSET}$ then inversely affects the subsequent conversion steps, that is to say is added with opposite sign compared to the first conversion step.

To this end, the ADC has a first operating configuration and a second operating configuration, the former adding the offset value $V_{OFFSET}$ with a positive sign $\left(V_{OUT_{CORE}} = 2V_{IN} \pm \dfrac{V_{REF}}{2} + V_{OFFSET}\right)$ and the latter adding the offset value $V_{OFFSET}$ with a negative sign $\left(V_{OUT_{CORE}} = 2V_{IN} \pm \dfrac{V_{REF}}{2} - V_{OFFSET}\right)$.

Thus the following equations of the voltage residues $V_{OUT\_CORE}$ are obtained:

$$V_{1,OUT_{CORE}} = 2V_{IN} + V_{OFFSET}$$

$$V_{2,OUT_{CORE}} = 2V_{1,OUT_{CORE}} - V_{OFFSET}$$

$$V_{3,OUT_{CORE}} = 2V_{2,OUT_{CORE}} - V_{OFFSET}$$

.

.

$$V_{N,OUT_{CORE}} = 2V_{N-1,OUT_{CORE}} - V_{OFFSET}$$

Therefore, in the residue voltage calculation, the resulting offset does not grow with the successive conversion steps. The final residue voltage is equal to: $V_{N,OUT_{CORE}} = 2^N V_{IN} + V_{OFFSET}$. Advantageously, the offset stays within the offset correction scheme range and thus it can be totally cancelled out of the final conversion result obtained with the overall conversion.

The stage 55, 58 as shown in FIG.5A and FIG.5B further comprises several decoupling capacitors serially inserted at the differential inputs and also between the positive/negative inputs and the negative/positive outputs, respectively.

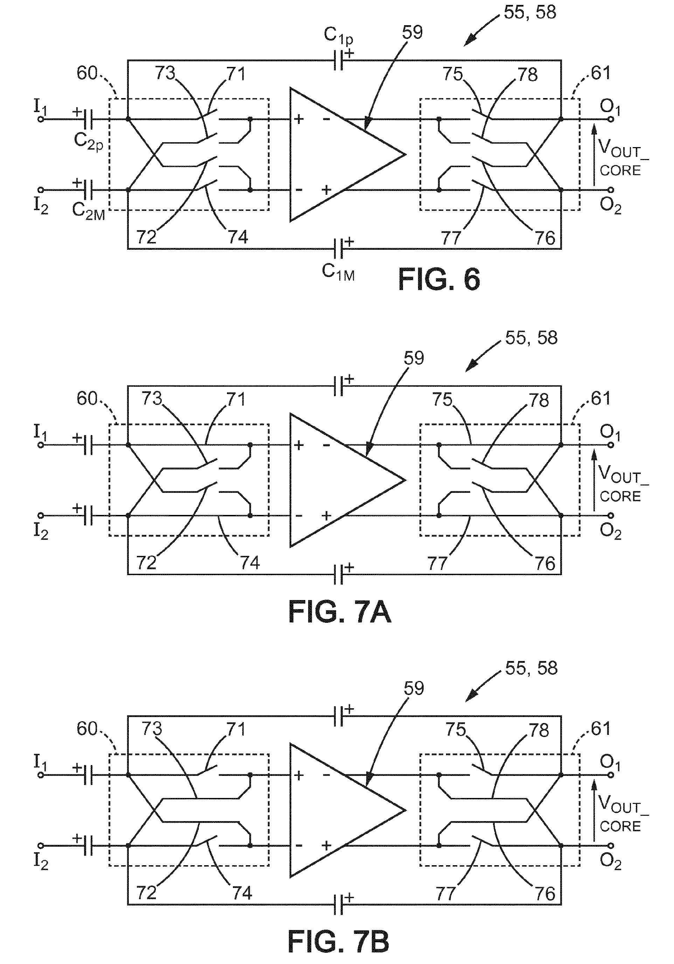

**FIG.6** illustrates the stage 55, 58 with multiplexing means adapted to set the stage 55, 58 in either one of the two operating configurations as shown in FIG.5A and FIG.5B, respectively. According to one embodiment, indeed, the proposed offset sign inversion can be simply implemented with a first differential multiplexer 60 arranged between the first and seconds inputs I1 and I2 of the stage 55, 58 and the two differential inputs of the amplifier 59, respectively. Similarly, a second differential multiplexer 61 can be arranged between the differential outputs of the amplifier 59 and the first and second outputs O1 and O2 of the stage 55, 58.

The first differential multiplexer 60 may be adapted to selectively couple a given ordered pair of said first and second inputs to one of first and second ordered pairs of the differential inputs in a first operating configuration of the stage 55, 58 and to couple said ordered pair of said first and second inputs to the other of said first and second ordered pairs of said differential inputs in a second operating configuration of the stage 55, 58. Similarly, the second differential multiplexer 61 may be adapted to selectively a given ordered pair of said differential outputs to one of first and second ordered pairs of said first and seconds outputs in the first operating configuration of the stage 55, 58, and to couple said ordered pair of said differential outputs to the other of said first and second ordered pairs of said first and second outputs in the second operating configuration of the stage 55, 58.

Each of the two above mentioned operating configurations is illustrated in **FIG.7A** and in **FIG.7B,** respectively. According to one embodiment, the first multiplexer 60 and/or the second multiplexer 61 can comprise 4 switches. For the first multiplexer 60, one switch 71 couples the first input I1 to the positive amplifier input of the amplifier 59, another switch 72 couples the first input I1 to the negative amplifier input of the amplifier 59. Also, one switch 73 couples the second input I2 to the positive amplifier input of the amplifier 59, and the last switch 74 couples the second input I2 to the negative amplifier input of the amplifier 59. For the second multiplexer 61, one switch 76 couples the first output O1 to the positive amplifier output of the amplifier 59, another switch 75 couples the first output O1 to the negative amplifier output of the amplifier 59. Also, one switch 77 couples the second output 02 to the positive amplifier output of the amplifier 59, and the last switch 78 couples the second output 02 to the negative amplifier output of the amplifier 59.

The first operating configuration, as illustrated by FIG.5A and FIG.7A, for example, can correspond to the configuration adding with positive sign the offset value $V_{OFFSET}$. This is achieved by closing simultaneously the two switches 71 and 74 of the first multiplexer 60 and the two switches 75 and 77 of the second multiplexer 61. The second operating configuration, as illustrated by FIG.5B and FIG.7B, then corresponds to the configuration adding with negative sign the offset value $V_{OFFSET}$. This is achieved by closing simultaneously the two switches 73 and 72 of the first multiplexer 60 and the two switches 76 and 78 of the second multiplexer 61.

The first operating configuration further comprises coupling the input 41 of the ADC to the input of the SH circuit 45 for receiving the analog voltage $V_{IN}$ to be converted. On the contrary, the second operating configuration further comprises coupling the second input 46 of the controlled switch to the input of the SH circuit 45 for receiving the analog residue voltage $V_{OUT\_CORE}$ to be converted. In one embodiment, the first configuration occurs first and only once, that is to say during the first conversion step only; whereas the ADC is set in the second operating configuration during all the subsequent conversion steps.

A control unit 49 controls the first and second differential multiplexers 60 and 61 to set the stage 55, 58 in the first operating configuration for the performance of the first conversion step, and in the second operating configuration for the performance of the subsequent conversion steps. To drive the multiplexers 60 and 61, the control unit 49 may generate one digital signal that controls when each one of the controlled switches 71, 72, 73, 74, 75, 76, 77, 78 is to be closed. For example, one flip-flop gate is adapted to implement the control unit 49 with appropriate commutation signals. The same control unit also drives the controlled switch 47 to the desired state.

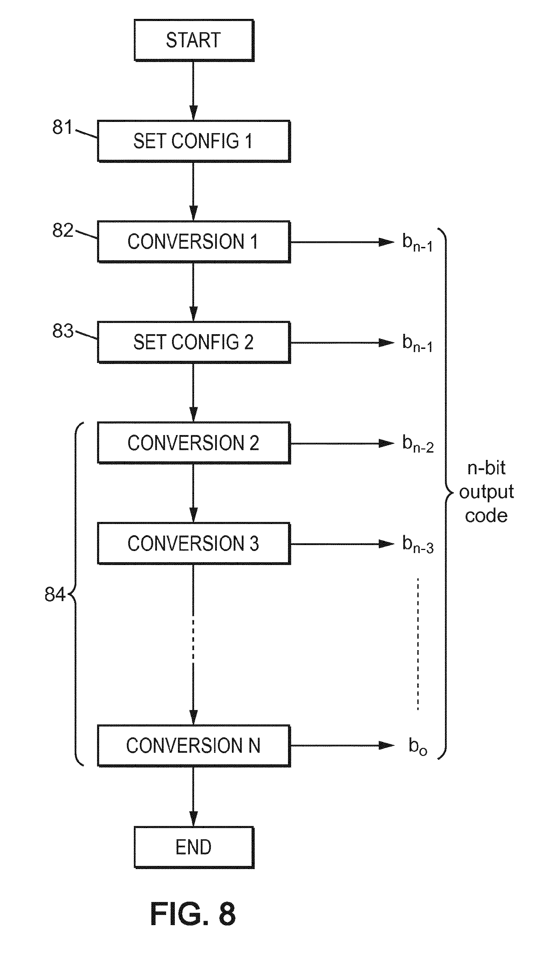

**FIG.8** is a flow chart illustrating steps of a method of analog-to-digital conversion according to one embodiment. To begin, the first operating configuration of the ADC is set at 81. Then the first conversion step 82 is carried out and the most significant bit (MSB), in this case is delivered by the conversion stage 50 to the digital block 56. Next, the second operating configuration is set at 83 and all the subsequent conversion steps 84 are carried out with the ADC being in this second operating configuration to provide the other bits until the least significant bit (LSB) is delivered which finishes the process.

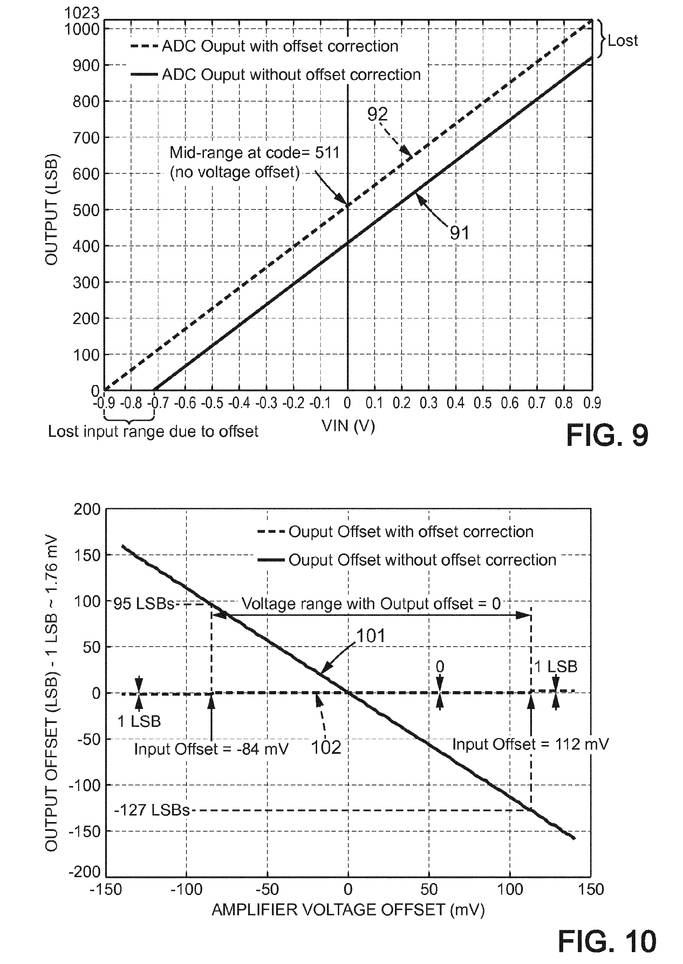

**FIG.9** shows the transfer characteristics 91 and 92 of an ADC which runs without offset correction 91 and with offset correction 92 according to embodiments as described herein. In this case the transfer characteristic refers to a static transfer function input/output of the ADC. The input voltage range is, for example, comprised between -0.9V and +0.9V, the offset value $V_{OFFSET}$ referred-input is approximately equal to 200mV, and the output codes is comprised between 0 and 1023. The transfer characteristic 92 is linear and has almost no voltage offset. This curve 92 is closer to the ideal ADC transfer characteristic 11 of an ADC as shown in FIG.1, than the transfer characteristic 91. Indeed, the transfer characteristic 92 has no offset, thus the input range loss and the output code loss are very low, and actually almost inexistent.

**FIG.10** shows the characteristic of output offset vs. amplifier voltage offset of the cyclic pipelined ADC according to embodiments as described herein. The offset value $V_{OFFSET}$ of the shown characteristic 101 without offset correction varies with the amplifier 59 offset value. On the contrary, the offset value $V_{OFFSET}$ of the characteristic 102 with offset correction remains equal to 0 within a large amplifier 59 offset range, for example, between -84mV and +112mV. When the amplifier 59 offset voltage is outside a full correction range, i.e. outside [-84mV,112mV], the offset value $V_{OFFSET}$ of the characteristic 102 is equal to $\pm$1LSB which , in most application, is considered not to be a problem.

With reference to FIG.10, the amplifier 59 offset range corresponding to an offset value $V_{OFFSET}$ equal to 0 is not centered on the origin. This stems from the fact that the amplifier 59 offset is applied with a sign which is dependent on whether the amplifier 59 is positively chopped (FIG.5A and FIG.7A) or negatively chopped (FIG.5B and FIG.7B) for the first conversion step. However the corresponding amplifier 59 offset range is large enough not to consider this unsymmetrical aspect, indeed the amplifier 59 offset value will be less than the extreme values of the range [-84mV, 112mV], which is generally assumed in most designs.

There are several advantages to the proposed solution as described above, indeed this is a very simple and cheap implementation of an offset correction since it requires only few switches with one digital signal to drive them. Hence this offset cancellation solution does not require extra area to implement the offset cancellation, neither complex schematic and the time to implement this solution is irrelevant.

Furthermore, this solution allows using an amplifier 59 with a large amplifier offset, which can enable to change the strategy of designing such amplifier. For some pipeline ADC, the amplifier gain should be really high and this can be achieved with an amplifier composed of at least 2 stages. However, even through 3 stages should be preferred; this would imply that the offset contributions would be larger than what is acceptable. With the proposed solution, however, the offset constraint can be completely relaxed for the design of the amplifier. For the transistors of the amplifier, it will thus be possible to achieve the same gm (for noise purpose) without imposing a large transistor length. Therefore, the amplifier size can be reduced, and a 3 stages amplifier can thus be used (also because the contribution of a supplementary stage will be also cancelled). The layout of the amplifier 59 will also be eased by the fact that the matching will not have to be accurate regarding offset contribution.

The differential multiplexers can be implemented by several switches as described above, but this does not limit the invention to this example Similarly, how many bits the core stage resolves at each conversion step is not limited to the shown examples. It may be determined in part by the target sampling rate and data latency, on one hand, and resolution and accuracy (also named Error Relative to Input, RTI, in %), on the other hand. In higher speed CMOS pipelined ADCs a lower number of bits per stage (as low as just one bit) may be favoured. For lower sampling-rate CMOS pipelined ADCs and bipolar pipelined ADCs (even those with a very high sampling rate) more bits may appear preferable to reduce data latency.

The present invention can also be embedded in a computer program product, which comprises all the features enabling the implementation of the methods described herein, and which - when loaded in an information processing system - is able to carry out these methods. Computer program means or computer program in the present context mean any expression, in any language, code or notation, of a set of instructions intended to cause a system having an information processing capability to perform a particular function either directly or after conversion to another language. Such a computer program can be stored on a computer or machine readable medium allowing data, instructions, messages or message packets, and other machine readable information to be read from the medium. The computer or machine readable medium may include non-volatile memory, such as ROM, Flash memory, Disk drive memory, CD-ROM, and other permanent storage. Additionally, a computer or machine readable medium may include, for example, volatile storage such as RAM, buffers, cache memory, and network circuits. Furthermore, the computer or machine readable medium may comprise computer or machine readable information in a transitory state medium such as a network link and/or a network interface, including a wired network or a wireless network, that allow a device to read such computer or machine readable information.

Expressions such as "comprise", "include", "incorporate", "contain", "is" and "have" are to be construed in a non-exclusive manner when interpreting the description and its associated claims, namely construed to allow for other items or components which are not explicitly defined also to be present. Reference to the singular is also to be construed in be a reference to the plural and vice versa.

While there has been illustrated and described what are presently considered to be the preferred embodiments of the present invention, it will be understood by those skilled in the art that various other modifications may be made, and equivalents may be substituted, without departing from the true scope of the present invention. Additionally, many modifications may be made to adapt a particular situation to the teachings of the present invention without departing from the central inventive concept described herein. Furthermore, an embodiment of the present invention may not include all of the features described above. Therefore, it is intended that the present invention not be limited to the particular embodiments disclosed, but that the invention include all embodiments falling within the scope of the appended claims.

A person skilled in the art will readily appreciate that various parameters disclosed in the description may be modified and that various embodiments disclosed and/or claimed may be combined without departing from the scope of the invention.

It is stipulated that the reference signs in the claims do not limit the scope of the claims, but are merely inserted to enhance the legibility of the claims.

## Claims

1. A cyclic pipelined Analog-to-Digital Converter (ADC) having:

   - an input (41) adapted to receive an analog voltage ($V_{IN}$) to be converted, and an output (42) adapted to deliver a n-bit digital value ($N_{OUT}$), where n is an integer greater than 1;
   - a core stage (40) comprising:

      - an Analog-to-Digital Conversion stage (50) adapted to compare the voltage between said differential inputs to at least one threshold value ($V_{REF}$, $V_{REF\_HIGH}$, $V_{REF\_LOW}$) and to provide at least one bit value of the n-bit digital value at each one of a plurality of successive conversion steps performed in loop by the core stage (40), respectively;
      - a stage (55, 58) having:

         - first and second inputs (I1,I2);
         - first and second outputs (01,02); and,
         - a differential inputs-differential outputs amplifier (59) adapted to compute a multiplication by 2 using a set of switched-capacitances;

- a differential inputs-single ended output comparator adapted to deliver a digital output;
- a Digital-to-Analog Converter (DAC) adapted to convert the digital output delivered by said comparator into a voltage level that is subtracted from the differential outputs of a multiplier (55) by 2,
- a load of capacitances (58) adapted to execute a voltage subtraction ;
- a first differential multiplexer (60) arranged between the first and second inputs (I1,I2) of the stage (55, 58) and the differential inputs of the amplifier (59), and adapted to selectively couple a given ordered pair of said first and second inputs to one of first and second ordered pairs of the differential inputs in a first operating configuration of the stage (55, 58) and to couple said ordered pair of said first and second inputs to the other of said first and second ordered pairs of said differential inputs in a second operating configuration of the stage (55, 58);
- a second differential multiplexer (61) arranged between the differential outputs of the amplifier (59) and the first and second outputs (01,02) of the stage (55, 58), and adapted to selectively a given ordered pair of said differential outputs to one of first and second ordered pairs of said first and seconds outputs in the first operating configuration of the stage (55, 58), and to couple said ordered pair of said differential outputs to the other of said first and second ordered pairs of said first and second outputs in the second operating configuration of the stage (55, 58);

- a control unit (49) adapted to control the first and second differential multiplexers (60, 61) to set the stage (55, 58) into the first operating configuration for the performance of the first conversion step of the plurality of conversion steps, and into the second operating configuration for the performance of any of the subsequent conversion steps of the plurality of conversion steps.

2. The converter of claim 1, wherein the conversion stage (50) is a 1.5 bits Analog-to-Digital Converter.

3. The converter of claim 2, wherein the conversion stage (50) is adapted to provide one bit value (b1) of the n-bit digital value along with a redundancy bit value (b0) at each one of the plurality of successive conversion steps.

4. The converter of any one of claims 1 to 3, further comprising:

- a controlled switch (47) having a first input coupled to the input (41) of the converter to receive the analog voltage ($V_{IN}$) to be converted, and a second input (46) to receive an analog residue voltage ($V_{OUT\_CORE}$) which depends on a previous conversion step, and corresponding to an output (44) of said core stage (40), and an output (48) coupled to said first input in a first operating configuration of the Analog-to-Digital Converter or to said second input in a second operating configuration of said converter;
- a Sample-and-Hold, SH circuit (45) having an input connected to the output of the controlled switch and adapted to capture a voltage value of the analog voltage ($V_{IN}$) to be converted in the first operating configuration of the Analog-to-Digital Converter or a voltage value of the analog residue voltage ($V_{OUT\_CORE}$) in the second operating configuration of said converter.

5. The converter of any one of claims 1 to 4, wherein the first differential multiplexer (60) comprises:

- two first controlled switches (71,72) adapted to couple the first input (11) to one of the differential inputs of the amplifier (59), respectively, in the first operating configuration of the stage (55, 58), and to the other of the differential inputs of the amplifier (59), in the second operating configuration of the stage (55, 58), respectively;
- two second controlled switches (73,74) adapted to couple the second input (I2) to one of the differential inputs of the amplifier (59), respectively, in the first operating configuration of the stage (55, 58), and to the other of the differential inputs of the amplifier (59), in the second operating configuration of the stage (55, 58), respectively.

6. The converter of any one of claims 1 to 5, wherein the second differential multiplexer (61) comprises:

- two first controlled switches (75,76) adapted to couple the first output (O1) to one of the differential outputs of the amplifier (59), respectively, in the first operating configuration of the stage (55, 58), and to the other of the differential outputs of the amplifier (59), in the second operating configuration of the stage (55, 58), respectively;
- two second controlled switches (77,78) adapted to couple the second output (02) to one of the differential outputs of the amplifier (59), respectively, in the first operating configuration of the stage (55, 58), and to the other of the differential outputs of the amplifier (59), in the second operating configuration of the stage (55, 58), respectively.

7. A computer program product comprising one or more stored sequences of instructions that are accessible to a processor and which, when executed by the processor, cause the processor to perform / to carry out the steps of any of claims 1 to 6.

FIG. 1

$V_1 = 2.V_{IN} - V_{REF}/2$  $V_2 = 2.V_1 + V_{REF}/2$  $V_3 = 2.V_2 - V_{REF}/2$

b3=1    b2=0    b1=1    b0=1

| 1 | 0 | 1 | 1 |

FIG. 2

$V_{MAX}$

$b_{OUT} = 1$

$V_{REF}$

$b_{OUT} = 0$

$V_{MIN}$

## FIG. 3A

$V_{MAX}$

$b_{OUT} = 1$ → $V_{OUT} = 2.V_{IN} - V_{REF}/2$
$b_{OUT} = 01$

$V_{REF.HIGHT}$

$b_{OUT} = $ unknown → $V_{OUT} = 2.V_{IN}$
$b_{OUT} = 10$

$V_{REF.LOW}$

$b_{OUT} = 0$ → $V_{OUT} = 2.V_{IN} + V_{REF}/2$
$b_{OUT} = 00$

$V_{MIN}$

## FIG. 3B

**FIG. 4**

$$V_{OUT\_CORE} = 2 \cdot V_{IN} \pm \frac{V_{REF}}{2}$$

**FIG. 5A**

**FIG. 5B**

FIG. 6

FIG. 7A

FIG. 7B

```
                    ┌──────────────┐
                    │    START     │
                    └──────┬───────┘
                           │
                           ▼
 81 ──────────────┌──────────────────┐
                  │   SET CONFIG 1   │
                  └────────┬─────────┘
                           │
                           ▼
 82 ──────────────┌──────────────────┐──────────▶ $b_{n-1}$  ⎫
                  │   CONVERSION 1   │                       ⎪
                  └────────┬─────────┘                       ⎪
                           │                                 ⎪
                           ▼                                 ⎪
 83 ──────────────┌──────────────────┐──────────▶ $b_{n-1}$  ⎪
                  │   SET CONFIG 2   │                       ⎪
                  └────────┬─────────┘                       ⎪
                           │                                 ⎪
                           ▼                                 ⎪
                  ┌──────────────────┐──────────▶ $b_{n-2}$  ⎬ n-bit
                  │   CONVERSION 2   │                       ⎪  output
                  └────────┬─────────┘                       ⎪  code
                           │                                 ⎪
                           ▼                                 ⎪
                  ┌──────────────────┐──────────▶ $b_{n-3}$  ⎪
        84 ⎨      │   CONVERSION 3   │                       ⎪
                  └────────┬─────────┘           ⋮           ⎪
                           ⋮                                 ⎪
                           ▼                                 ⎪
                  ┌──────────────────┐──────────▶ $b_{o}$    ⎭
                  │   CONVERSION N   │
                  └────────┬─────────┘
                           │
                           ▼
                    ┌──────────────┐
                    │     END      │
                    └──────────────┘
```

## FIG. 8

FIG. 9

FIG. 10

Europäisches
Patentamt

European
Patent Office

Office européen
des brevets

# EUROPEAN SEARCH REPORT

**Application Number**

EP 14 30 6111

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 2 058 948 A1 (MITSUMI ELECTRIC CO [JP]) 13 May 2009 (2009-05-13) * paragraphs [0005], [0024], [0034], [0038], [0045], [0052], [0065]; figures 1,2,3,5,7,13 * | 1-7 | INV. H03M1/06 H03M1/40 |
| X | KAIMING NIE ET AL: "A 10-bit ratio-independent cyclic ADC with offset canceling for a CMOS image sensor", JOURNAL OF SEMICONDUCTORS, vol. 35, no. 3, 1 March 2014 (2014-03-01), page 035005, XP055159823, ISSN: 1674-4926, DOI: 10.1088/1674-4926/35/3/035005 * Section 2.1; Section 2.2; figures 1,3,4 * | 1-7 | |
| X | JARVINEN J A M ET AL: "A 12-Bit Ratio-Independent Algorithmic A/D Converter for a Capacitive Sensor Interface", IEEE TRANSACTIONS ON CIRCUITS AND SYSTEMS I: REGULAR PAPERS, IEEE, US, vol. 55, no. 3, 1 April 2008 (2008-04-01), pages 730-740, XP011333087, ISSN: 1549-8328, DOI: 10.1109/TCSI.2008.919749 * Section III; Section IV; figures 1,3,5 * | 1-7 | |

**TECHNICAL FIELDS SEARCHED (IPC)**

H03M

The present search report has been drawn up for all claims

| Place of search | Date of completion of the search | Examiner |
|---|---|---|
| The Hague | 26 January 2015 | Jesus, Paulo |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 14 30 6111

This annex lists the patent family members relating to the patent documents cited in the above-mentioned European search report.
The members are as contained in the European Patent Office EDP file on
The European Patent Office is in no way liable for these particulars which are merely given for the purpose of information.

26-01-2015

| Patent document cited in search report | | Publication date | Patent family member(s) | | Publication date |
|---|---|---|---|---|---|
| EP 2058948 | A1 | 13-05-2009 | CN | 101512907 A | 19-08-2009 |
| | | | EP | 2058948 A1 | 13-05-2009 |
| | | | JP | 4853186 B2 | 11-01-2012 |
| | | | JP | 2008060956 A | 13-03-2008 |
| | | | US | 2010225514 A1 | 09-09-2010 |
| | | | WO | 2008026481 A1 | 06-03-2008 |

EPO FORM P0459

For more details about this annex : see Official Journal of the European Patent Office, No. 12/82